# EUROPEAN PATENT APPLICATION

(11) **EP 4 535 418 A1**
(43) Date of publication of application: **09.04.2025**
(21) Application number: 23816321.6
(22) Date of filing: 30.05.2023
(51) Int. Cl.: H01L 23/367, H05K 7/20

(54) **HEAT SINK STRUCTURE AND MANUFACTURING METHOD THEREOF**

(30) Priority: 02.06.2022 KR 20220067508; 25.05.2023 KR 20230067447
(71) Applicant: KMW Inc., Hwaseong-si, Gyeonggi-do 18462 (KR)
(72) Inventor: KIM, Duk Yong, Yongin-si Gyeonggi-do 17086 (KR); JI, Kyo Sung, Hwaseong-si Gyeonggi-do 18484 (KR); KIM, Dong Won, Bucheon-si Gyeonggi-do 14574 (KR); HAN, Kyu Tae, Incheon 21387 (KR); LEE, Hwang Ju, Incheon 22627 (KR); CHOI, In Hwa, Yongin-si Gyeonggi-do 17148 (KR)
(74) Representative: Impuls legal PartG mbB
(86) International application number: PCT/KR2023/007335
(87) International publication number: WO 2023/234660

(57) **Abstract**

The present invention relates to a heat sink structure and a manufacturing method thereof, in which a plurality of heat radiation fin parts, which is configured to radiate heat, is fixed to a heat radiation surface of a heat sink main body part by laser welding, such that thicknesses of and intervals between the plurality of heat radiation fin parts may be minimized, heat dissipation performance may be improved, a weight may be greatly reduced, and production lead time and manufacturing costs may be significantly reduced by manufacturing only the heat sink main body part by casting.

## Description

### [Technical Field]

The present invention relates to a heat sink structure and a manufacturing method thereof, and more particularly, to a heat sink structure, in which heat radiation fins are joined to a heat sink main body by laser welding, and a manufacturing method thereof.

### [Background Art]

In general, a heat sink may be installed in a product that is required to dissipate heat, and the heat sink may effectively dissipate heat.

The heat sinks are applied to various products in electronic, machinery, and automotive industries, such as LED lighting, semiconductor manufacturing equipment, computers, medical devices, and radiation application machines to prevent damage caused by heat and enable stable operations. The heat sinks are modified and applied in various shapes that suit the products.

Typically, the heat sink has a structure in which a heat sink main body has a mounting surface on which a product, which is required to dissipate heat, is mounted, and a plurality of heat radiation fins stands on an opposing surface to the mounting surface, such that the heat sink quickly dissipates heat, which is generated from the product, by means of heat exchange between air and the heat radiation fins.

Korean Patent No. 10-0381303 (published on April 26, 2003) (hereinafter, referred to as 'the related art') discloses a 'porous heat sink'.

The heat sink in the related art is manufactured by extrusion or casting and has a structure in which a heat radiation plate, which is the heat sink main body, and the plurality of heat radiation fins are integrated.

However, the heat sink in the related art is manufactured by extrusion or casting, and the heat radiation plate and the plurality of heat radiation fins are integrated, which makes it difficult to reduce thicknesses of and intervals between the plurality of heat radiation fins. For this reason, the number of heat radiation fins is small, which causes a problem in that heat dissipation performance is restricted, and it is difficult to reduce the weight.

In addition, because the heat sink in the related art is manufactured by extrusion or casting, a complicated mold needs to be designed to form the plurality of heat radiation fins. For this reason, a large amount of manufacturing costs is required, and the mold needs to be separately manufactured in a shape that suits the product, which causes a problem in that a large amount of time is required to design and manufacture the mold, and a defect rate is high during a manufacturing process.

### [Disclosure]

### [Technical Problem]

The technical object of the present invention is to provide a heat sink structure, in which a heat sink main body part and a plurality of heat radiation fin parts are manufactured separately, and the plurality of heat radiation fin parts is fixed to the heat sink main body part by laser welding, such that thicknesses of and intervals between the plurality of heat radiation fin parts may be minimized, and manufacturing costs may be significantly reduced, and a manufacturing method thereof.

The technical problems of the present invention are not limited to the aforementioned technical problem, and other technical problems, which are not mentioned above, may be clearly understood by those skilled in the art from the following descriptions.

### [Technical Solution]

In order to achieve the above-mentioned object, a heat sink structure according to the present invention includes a heat sink main body part and a plurality of heat radiation fin parts. A mounting surface is provided on one surface of the heat sink main body part, and a product from which heat is to be dissipated is positioned on the mounting surface. A heat radiation surface for dissipating heat is provided on a surface different from one surface of the heat sink main body part. The plurality of heat radiation fin parts is fixed by laser welding while standing on the heat radiation surface of the heat sink main body part.

A plurality of welding coupling parts may protrude from the heat radiation surface of the heat sink main body part. The plurality of heat radiation fin parts may be respectively coupled to the plurality of welding coupling parts by laser welding.

The plurality of welding coupling parts may each include a first heat radiation fin support portion. The first heat radiation fin support portion may protrude from the heat radiation surface. A lower end of each of the plurality of heat radiation fin parts may be disposed at one side of the first heat radiation fin support portion and stand on the heat radiation surface. The first heat radiation fin support portion may support one side of each of the plurality of heat radiation fin parts. A portion between one side of each of the plurality of heat radiation fin parts and one side of the first heat radiation fin support portion may be fixed by laser welding.

The plurality of welding coupling parts may each include a first heat radiation fin support portion and a second heat radiation fin support portion. The first heat radiation fin support portion may protrude from the heat radiation surface. The second heat radiation fin support portion may protrude from the heat radiation surface and be spaced apart from the first heat radiation fin support portion. A lower end of each of the plurality of heat radiation fin parts may be inserted between the first heat radiation fin support portion and the second heat radiation fin support portion and stand on the heat radiation surface. The first heat radiation fin support portion may support one side of each of the plurality of heat radiation fin parts. The second heat radiation fin support portion may support the other side of each of the plurality of heat radiation fin parts. One of a portion between one side of each of the plurality of heat radiation fin parts and one side of the first heat radiation fin support portion and a portion between the other side of each of the plurality of heat radiation fin parts and one side of the second heat radiation fin support portion may be fixed by laser welding.

The plurality of welding coupling parts may each include a support block portion. The support block portion may protrude from the heat radiation surface. A lower end of each of the plurality of heat radiation fin parts may stand on the support block portion and be fixed to the support block portion by laser welding.

The plurality of welding coupling parts may each include a support block portion, a first heat radiation fin support portion, and a second heat radiation fin support portion. The support block portion may protrude from the heat radiation surface. The first heat radiation fin support portion may protrude from one end of the support block portion. The second heat radiation fin support portion may protrude from the other end of the support block portion and be spaced apart from the first heat radiation fin support portion. A lower end of each of the plurality of heat radiation fin parts may be inserted between the first heat radiation fin support portion and the second heat radiation fin support portion and stand on the support block portion. The first heat radiation fin support portion may support one side of each of the plurality of heat radiation fin parts. The second heat radiation fin support portion may support the other side of each of the plurality of heat radiation fin parts. One of a portion between one side of each of the plurality of heat radiation fin parts and one side of the first heat radiation fin support portion and a portion between the other side of each of the plurality of heat radiation fin parts and one side of the second heat radiation fin support portion may be fixed by laser welding.

A thickness of the first heat radiation fin support portion may be 0.7 to 1.1 times a thickness of each of the plurality of heat radiation fin parts.

A height of the first heat radiation fin support portion may be 1 to 2 times the thickness of each of the plurality of heat radiation fin parts.

A thickness of the second heat radiation fin support portion may be 0.7 to 1.1 times the thickness of each of the plurality of heat radiation fin parts.

A height of the second heat radiation fin support portion may be 1 to 2 times the thickness of each of the plurality of heat radiation fin parts.

A thickness of the support block portion may be 2.4 to 3.3 times the thickness of each of the plurality of heat radiation fin parts.

The plurality of heat radiation fin parts may each include a plate support member and a heat radiation fin member. The heat radiation fin member may be disposed on at least one of two opposite ends of the plate support member while standing.

The heat radiation fin member may include a perpendicular fin. The perpendicular fin may be disposed on at least one of the two opposite ends of the plate support member and disposed perpendicularly to the plate support member.

The heat radiation fin members may include inclined fins formed at the two opposite ends of the plate support member. The inclined fins formed at the two opposite ends of the plate support member may be inclined such that a distance between the inclined fins increases as the distance from the plate support member increases.

The heat radiation fin members may further include perpendicular fins extending perpendicularly to the plate support member from ends of the inclined fins formed at the two opposite ends of the plate support member.

In order to achieve the above-mentioned object, a heat sink structure manufacturing method according to the present invention includes a preparation step and a laser welding step. In the preparation step, the heat sink main body part and the plurality of heat radiation fin parts are manufactured separately. A mounting surface is provided on one surface of the heat sink main body part, and a product from which heat is to be dissipated is positioned on the mounting surface. A heat radiation surface for dissipating heat is provided on a surface different from one surface of the heat sink main body part. The plurality of heat radiation fin parts dissipate heat. In the laser welding step, the plurality of heat radiation fin parts is fixed to the heat radiation surface of the heat sink main body part by laser welding and spaced apart from one another.

In the preparation step, the heat sink main body part may be manufactured by casting, and the plurality of heat radiation fin parts may be manufactured by cutting a premanufactured metal plate.

In the preparation step, a plurality of welding coupling parts may protrude from the heat radiation surface of the heat sink main body part. In the laser welding step, the plurality of heat radiation fin parts may be respectively coupled to the plurality of welding coupling parts by laser welding.

Other detailed matters of the embodiment are included in the detailed description and the drawings.

### [Advantageous Effects]

According to the present invention, the heat sink main body part and the plurality of heat radiation fin parts are manufactured separately, and then the plurality of heat radiation fin parts is fixed to the heat sink main body part by laser welding, such that the thicknesses of and the intervals between the plurality of heat radiation fin parts may be minimized, the heat dissipation performance may be improved, and the weight may be significantly reduced.

In addition, according to the present invention, only the heat sink main body part is manufactured by casting, which may significantly reduce the production lead time and the manufacturing costs.

The effects of the present invention are not limited to the aforementioned effects, and other effects, which are not mentioned above, will be clearly understood by those skilled in the art from the claims.

### [Description of Drawings]

FIG. 1 is a bottom perspective view illustrating an embodiment of a heat sink structure according to the present invention.
FIG. 2 is a top perspective view illustrating the embodiment of the heat sink structure according to the present invention.
FIG. 3 is a side view illustrating the embodiment of the heat sink structure according to the present invention.
FIGS. 4 and 5 are enlarged views of a part of the embodiment of the heat sink structure according to the present invention.
FIG. 6 is an enlarged view of a part of another embodiment of the heat sink structure according to the present invention.
FIGS. 7 to 10 are views illustrating another shape of a heat radiation fin part of the heat sink structure according to the present invention.
FIG. 11 is a photograph of a first test example in which the heat radiation fin part is laser-welded by a heat sink manufacturing method according to the present invention.
FIG. 12 is a photograph of a second test example in which the heat radiation fin part is laser-welded by the heat sink manufacturing method according to the present invention.

### <Explanation of Reference Numerals and Symbols>

1: Heat sink structure100: Heat sink main body part
101: Mounting surface 102: Heat radiation surface
107: Welding coupling part 110: First heat radiation fin support portion
120: Second heat radiation fin support portion 130: Support block portion
200: Heat radiation fin part 210: Plate support member
220: Heat radiation fin member 221: Perpendicular fin
222: Inclined fin

### [Best Mode]

The present invention may be variously modified and may have various embodiments, and particular embodiments illustrated in the drawings will be described in detail below.

However, the description of the embodiments is not intended to limit the present invention to the particular embodiments, but it should be understood that the present invention is to cover all modifications, equivalents and alternatives falling within the spirit and technical scope of the present invention. In the description of the drawings, similar reference numerals are used for similar constituent elements.

When one constituent element is described as being "coupled" or "connected" to another constituent element, it should be understood that one constituent element can be coupled or connected directly to another constituent element, and an intervening constituent element can also be present between the constituent elements. When one constituent element is described as being "coupled directly to" or "connected directly to" another constituent element, it should be understood that no intervening constituent element is present between the constituent elements.

The terminology used herein is used for the purpose of describing particular embodiments only and is not intended to limit the present invention. Singular expressions include plural expressions unless clearly described as different meanings in the context. The terms "comprises," "comprising," "includes," "including," "containing," "has," "having" or other variations thereof are inclusive and therefore specify the presence of stated features, integers, steps, operations, elements, components, and/or combinations thereof, but do not preclude the presence or addition of one or more other features, integers, steps, operations, elements, components, and/or combinations thereof.

Hereinafter, exemplary embodiments of the present invention will be described in more detail with reference to the accompanying drawings. Hereinafter, in the drawings, the same constituent elements will be designated by the same reference numerals, and the repetitive description of the same constituent elements will be omitted.

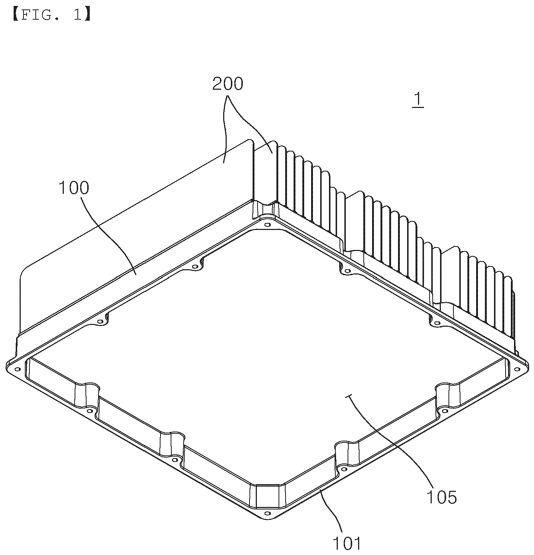

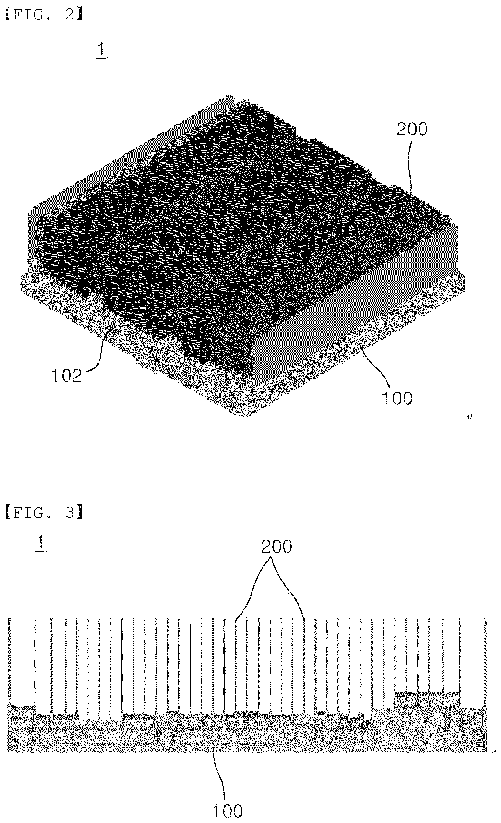

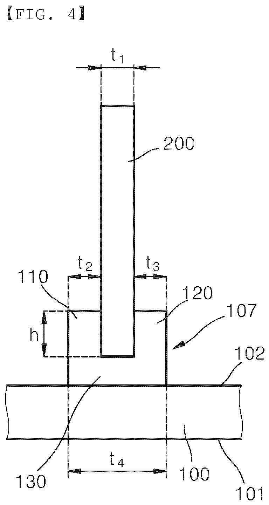

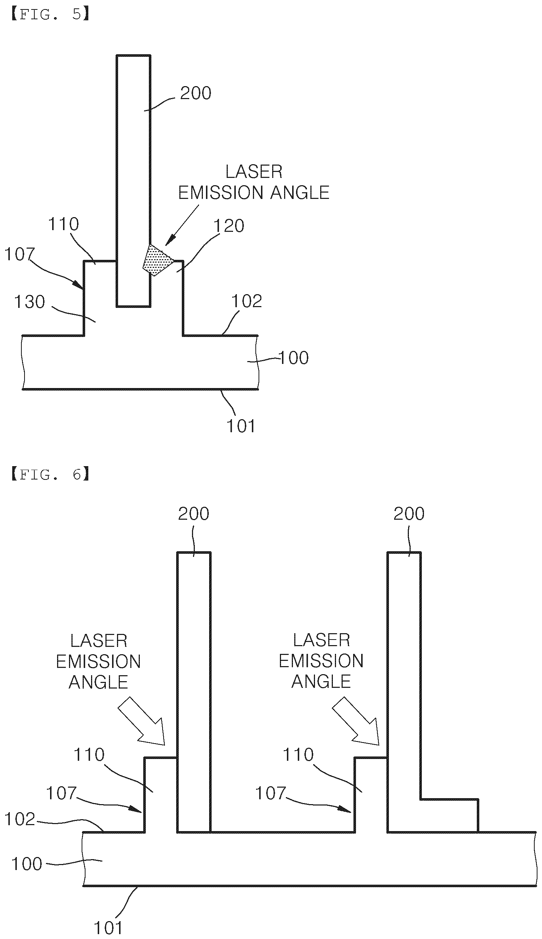

FIG. 1 is a bottom perspective view illustrating an embodiment of a heat sink structure according to the present invention, FIG. 2 is a top perspective view illustrating the embodiment of the heat sink structure according to the present invention, FIG. 3 is a side view illustrating the embodiment of the heat sink structure according to the present invention, and FIGS. 4 and 5 are enlarged views of a part of the embodiment of the heat sink structure according to the present invention.

In more detail, FIG. 4 is a view illustrating an example in which heat radiation fin parts 200 are coupled to a heat sink main body part 100 before laser welding, and FIG. 5 is a view illustrating an example in which the heat radiation fin parts 200 are fixed to the heat sink main body part 100 after laser welding.

An embodiment of a heat sink structure 1 according to the present invention will be described below in detail with reference to FIGS. 1 to 5.

The embodiment of the heat sink structure 1 according to the present invention includes the heat sink main body part 100 having one surface, i.e., a mounting surface 101 on which a product from which heat is to be dissipated is positioned.

In the present embodiment, an accommodation space 105 may be formed in the mounting surface 101 of the heat sink main body part 100 and accommodate the product. However, the heat sink main body part 100 may be formed in a plate shape in which the accommodation space 105 is not formed.

A heat radiation surface 102, to which a plurality of heat radiation fin parts 200 configured to dissipate heat by means of heat exchange is fixed, is positioned on the other surface of the heat sink main body part 100.

For example, the heat radiation surface 102 of the heat sink main body part 100 is an opposing surface to the mounting surface 101. Alternatively, the heat radiation surface 102 may change to a surface different from the mounting surface 101 in accordance with the design of the product.

For example, the heat radiation fin part 200 has a straight panel shape. Alternatively, the heat radiation fin part 200 may be manufactured in various shapes such as a curved panel shape or a rod shape.

For example, the heat sink main body part 100 and the heat radiation fin part 200 are made of aluminum or aluminum alloy. Alternatively, the heat sink main body part 100 and the heat radiation fin part 200 may be variously manufactured by using publicly-known material with excellent thermal conduction that is used to manufacture a heat sink.

Further, for example, the heat sink main body part 100 is manufactured in a predesigned shape by casting, and the heat radiation fin part 200 is manufactured by cutting a premanufactured aluminum or aluminum alloy panel into a predesigned size.

The heat radiation fin part 200 is seated and positioned on the heat radiation surface 102 of the heat sink main body part 100 while standing. The heat radiation fin part 200 is fixed onto the heat radiation surface 102 of the heat sink main body part 100 by laser welding in the state in which the heat radiation fin part 200 is seated on the heat radiation surface 102 of the heat sink main body part 100.

In a state in which an end of the heat radiation fin part 200 is seated on the heat radiation surface 102 of the heat sink main body part 100, the laser welding is performed by irradiating a boundary line between the heat sink main body part 100 and the heat radiation fin part 200, i.e., an edge of a lower end of the heat radiation fin part 200, which meets the heat radiation surface 102, with laser beams, such that the heat radiation fin part 200 is fixed onto the heat radiation surface 102 of the heat sink main body part 100 by welding.

The heat sink structure 1 according to the present invention is manufactured by manufacturing the heat sink main body part 100 by casting, manufacturing the heat radiation fin part 200 separately from the heat sink main body part 100, and fixing the heat radiation fin part 200 to the heat sink main body part 100 by laser welding.

Meanwhile, a plurality of welding coupling parts 107 may protrude from the heat radiation surface 102 of the heat sink main body part 100, and the plurality of heat radiation fin parts 200 may be respectively coupled to the plurality of welding coupling parts 107 by laser welding.

The plurality of welding coupling parts 107 may each include a first heat radiation fin support portion 110, a second heat radiation fin support portion 120, and a support block portion 130.

However, the plurality of welding coupling parts 107 may each include only the first heat radiation fin support portion 110, include only the first heat radiation fin support portion 110 and the second heat radiation fin support portion 120, or include only the support block portion 130.

In case that the plurality of welding coupling parts 107 each includes the first heat radiation fin support portion 110, the second heat radiation fin support portion 120, and the support block portion 130, the support block portion 130 may protrude from the heat radiation surface 102, and the first heat radiation fin support portion 110 and the second heat radiation fin support portion 120 may protrude from two opposite ends of the support block portion 130 and be spaced apart from each other. That is, the first heat radiation fin support portion 110 may protrude from one end of the support block portion 130, and the second heat radiation fin support portion 120 may protrude from the other end of the support block portion 130 and be spaced apart from the first heat radiation fin support portion 110. In this case, the lower end of each of the plurality of heat radiation fin parts 200 is inserted between the first heat radiation fin support portion 110 and the second heat radiation fin support portion 120 and stands on the support block portion 130, such that the first heat radiation fin support portion 110 may support one side of each of the plurality of heat radiation fin parts 200, and the second heat radiation fin support portion 120 may support the other side of each of the plurality of heat radiation fin parts 200. Further, one of a portion between one side of each of the plurality of heat radiation fin parts 200 and one side of the first heat radiation fin support portion 110 and a portion between the other side of each of the plurality of heat radiation fin parts 200 and one side of the second heat radiation fin support portion 120 may be fixed by laser welding.

In case that the plurality of welding coupling parts 107 each includes only the first heat radiation fin support portion 110, the first heat radiation fin support portion 110 may protrude from the heat radiation surface 102. In this case, the lower end of each of the plurality of heat radiation fin parts 200 is disposed at one side of the first heat radiation fin support portion 110 and stands on the heat radiation surface 102, such that the first heat radiation fin support portion 110 may support one side of each of the plurality of heat radiation fin parts 200. Further, a portion between one side of each of the plurality of heat radiation fin parts 200 and one side of the first heat radiation fin support portion 110 may be fixed by laser welding.

In case that the plurality of welding coupling parts 107 each includes only the first heat radiation fin support portion 110 and the second heat radiation fin support portion 120, the first heat radiation fin support portion 110 and the second heat radiation fin support portion 120 may protrude from the heat radiation surface 102 and be spaced apart from each other. That is, the first heat radiation fin support portion 110 may protrude from the heat radiation surface 102, and the second heat radiation fin support portion 120 may protrude from the heat radiation surface 102 and be spaced apart from the first heat radiation fin support portion 110. In this case, the lower end of each of the plurality of heat radiation fin parts 200 is inserted between the first heat radiation fin support portion 110 and the second heat radiation fin support portion 120 and stands on the heat radiation surface 102, such that the first heat radiation fin support portion 110 may support one side of each of the plurality of heat radiation fin parts 200, and the second heat radiation fin support portion 120 may support the other side of each of the plurality of heat radiation fin parts 200. Further, one of a portion between one side of each of the plurality of heat radiation fin parts 200 and one side of the first heat radiation fin support portion 110 and a portion between the other side of each of the plurality of heat radiation fin parts 200 and one side of the second heat radiation fin support portion 120 may be fixed by laser welding.

In case that the plurality of welding coupling parts 107 each includes only the support block portion 130, the support block portion 130 may protrude from the heat radiation surface 102. In this case, the lower end of each of the plurality of heat radiation fin parts 200 may stand on the support block portion 130. Further, the lower end of each of the plurality of heat radiation fin parts 200 may be fixed to the support block portion 130 by laser welding.

In case that the plurality of welding coupling parts 107 each includes the support block portion 130, the support block portion 130 may protrude from the heat radiation surface 102 of the heat sink main body part 100.

In case that each of the plurality of welding coupling parts 107 does not include the support block portion 130, the first heat radiation fin support portion 110 may protrude from the heat radiation surface 102 of the heat sink main body part 100, or the first heat radiation fin support portion 110 and the second heat radiation fin support portion 120 may protrude from the heat radiation surface 102 of the heat sink main body part 100.

In case that the plurality of welding coupling parts 107 each includes the first heat radiation fin support portion 110 and the second heat radiation fin support portion 120, one end of each of the plurality of heat radiation fin parts 200 may be inserted between the first heat radiation fin support portion 110 and the second heat radiation fin support portion 120.

The first heat radiation fin support portion 110 and the second heat radiation fin support portion 120 are spaced apart from each other at an interval equal to or finely larger than a thickness t₁ of the heat radiation fin part 200, such that the heat radiation fin part 200 is fitted and inserted between the first heat radiation fin support portion 110 and the second heat radiation fin support portion 120.

For example, the first heat radiation fin support portion 110 and the second heat radiation fin support portion 120 are spaced apart from each other at an interval of 1 to 1.2 times the thickness t₁ of the heat radiation fin part 200, such that the heat radiation fin part 200 is fitted and inserted between the first heat radiation fin support portion 110 and the second heat radiation fin support portion 120.

Further, for example, a thickness t₂ of the first heat radiation fin support portion 110 and a thickness t₃ of the second heat radiation fin support portion 120 are equal to or finely larger or smaller than the thickness t₁ of each of the plurality of heat radiation fin parts 200. In more detail, for example, the thickness t2 of the first heat radiation fin support portion 110 and the thickness t3 of the second heat radiation fin support portion 120 are each 0.7 to 1.1 times the thickness t1 of the heat radiation fin part 200.

The first heat radiation fin support portion 110 and the second heat radiation fin support portion 120 may serve to increase a fixing force for the heat radiation fin part 200 by supporting the two opposite sides of the heat radiation fin part 200 fixed by laser welding and also serves as a filler material by being melted during laser welding.

One of the first heat radiation fin support portion 110 and the second heat radiation fin support portion 120 serve as a filler material by being melted during laser welding. In this case, in case that the thickness t₂ of the first heat radiation fin support portion 110 and the thickness t₃ of the second heat radiation fin support portion 120 are each as large as more than 1.1 times the thickness t₁ of each of the plurality of heat radiation fin parts 200, there is a problem in that it is difficult for one of the first heat radiation fin support portion 110 and the second heat radiation fin support portion 120 to serve as a filler material during laser welding. In case that the thickness t₂ of the first heat radiation fin support portion 110 and the thickness t₃ of the second heat radiation fin support portion 120 are each as small as less than 0.7 times the thickness t₁ of each of the plurality of heat radiation fin parts 200, there is a problem in that the rigidity for supporting the heat radiation fin part 200, i.e., the rigidity of the opposing side to the welded portion is insufficient. Therefore, the thickness t₂ of the first heat radiation fin support portion 110 and the thickness t₃ of the second heat radiation fin support portion 120 may be 0.7 to 1.1 times the thickness t₁ of each of the plurality of heat radiation fin parts 200.

In addition, a height h of the first heat radiation fin support portion 110 and a height h of the second heat radiation fin support portion 120 may each be 1 to 2 times the thickness t₁ of each of the plurality of heat radiation fin parts 200.

In case that the height h of the first heat radiation fin support portion 110 and the height h of the second heat radiation fin support portion 120 are each smaller than the thickness t₁ of each of the plurality of heat radiation fin parts 200, the rigidity for supporting the two opposite surfaces of the heat radiation fin part 200 may be insufficient. In case that the height h of the first heat radiation fin support portion 110 and the height h of the second heat radiation fin support portion 120 are each as large as more than 2 times the thickness t₁ of each of the plurality of heat radiation fin parts 200, the heat dissipation effect may deteriorate. Therefore, the height h of the first heat radiation fin support portion 110 and the height h of the second heat radiation fin support portion 120 may each be 1 to 2 times the thickness t₁ of each of the plurality of heat radiation fin parts 200.

A thickness t₄ of the support block portion 130 is 2.4 to 3.3 times the thickness t₁ of the heat radiation fin part 200. The thickness t₄ is a thickness that may be stably defined at an end of the first heat radiation fin support portion 110 and an end of the second heat radiation fin support portion 120, i.e., a thickness that does not affect the intervals between the heat radiation fin parts 200.

That is, in case that the thickness t₄ of the support block portion 130 is as large as more than 3.3 times the thickness t₁ of each of the plurality of heat radiation fin parts 200, the number of heat radiation fin parts 200 installed on the heat sink main body part 100 is small, which degrades the heat dissipation performance. In case that the thickness t₄ of the support block portion 130 is as small as less than 2.4 times the thickness t₁ of each of the plurality of heat radiation fin parts 200, there is a problem in that it is difficult for the first heat radiation fin support portion 110 and the second heat radiation fin support portion 120 to have sufficient thicknesses. Therefore, the thickness t₄ of the support block portion 130 may be 2.4 to 3.3 times the thickness t₁ of each of the plurality of heat radiation fin parts 200.

The support block portion 130 allows the heat radiation fin parts 200 to be positioned on the heat radiation surface 102 of the heat sink main body part 100 and spaced apart from each other, such that the laser-welded portion is positioned at a predesigned height or more on the heat radiation surface 102 of the heat sink main body part 100, which may prevent the mounting surface 101 of the heat sink main body part 100 from being bent by heat after laser welding.

During the laser welding, any one of the first heat radiation fin support portion 110 and the second heat radiation fin support portion 120 serves as a filler material to be melted together with the heat radiation fin part 200. After the laser welding, the heat radiation fin part 200 is fixed between the first heat radiation fin support portion 110 and the second heat radiation fin support portion 120 by laser welding.

The heat radiation fin part 200 is inserted between the first heat radiation fin support portion 110 and the second heat radiation fin support portion 120 and then laser-welded at any one side of the first heat radiation fin support portion 110 and the second heat radiation fin support portion 120, such that the heat radiation fin part 200 is securely fixed between the first heat radiation fin support portion 110 and the second heat radiation fin support portion 120.

After laser welding, the heat radiation fin part 200 is supported by the first heat radiation fin support portion 110 and the second heat radiation fin support portion 120, and the rigidity is improved in both the two directions, such that the heat radiation fin part 200 may be securely fixed onto the heat radiation surface 102 of the heat sink main body part 100.

FIG. 6 is an enlarged view of a part of another embodiment of the heat sink structure according to the present invention.

With reference to FIG. 6, the heat sink structure 1 according to the present invention may include the first heat radiation fin support portion 110 protruding from the heat radiation surface of the heat sink main body part 100 and configured to support one side of the heat radiation fin part 200.

For example, a thickness of the first heat radiation fin support portion 110 is equal to or smaller than a thickness of the heat radiation fin part 200. In more detail, for example, the thickness of the first heat radiation fin support portion 110 is 0.7 to 1.1 times the thickness of the heat radiation fin part 200.

During laser welding, the laser beams are emitted in an inclined direction between the first heat radiation fin support portion 110 and the heat radiation fin part 200.

Further, the first heat radiation fin support portion 110 may serve to increase a fixing force for the heat radiation fin part 200 by supporting one side of the heat radiation fin part 200 fixed by laser welding and also serves as a filler material by being melted during laser welding.

The first heat radiation fin support portion 110 serves as a filler material by being melted during laser welding. In this case, in case that the thickness of the first heat radiation fin support portion 110 is as large as more than 1.1 times the thickness of each of the plurality of heat radiation fin parts 200, there is a problem in that it is difficult for the first heat radiation fin support portion 110 to serve as a filler material during laser welding. In case that the thickness of the first heat radiation fin support portion 110 is as small as less than 0.7 times the thickness of each of the plurality of heat radiation fin parts 200, there is a problem in that the rigidity for supporting the heat radiation fin part 200, i.e., the rigidity of the opposing side to the welded portion is insufficient. Therefore, the thickness t2 of the first heat radiation fin support portion 110 may be 0.7 to 1.1 times the thickness t₁ of each of the plurality of heat radiation fin parts 200.

In addition, the height of the first heat radiation fin support portion 110 may be 1 to 2 times the thickness of each of the plurality of heat radiation fin parts 200.

In case that the height of the first heat radiation fin support portion 110 is smaller than the thickness of each of the plurality of heat radiation fin parts 200, the rigidity for supporting the two opposite surfaces of the heat radiation fin part 200 may be insufficient. In case that the height of the first heat radiation fin support portion 110 is as large as more than 2 times the thickness of each of the plurality of heat radiation fin parts 200, the heat dissipation effect may deteriorate. Therefore, the height h of the first heat radiation fin support portion 110 may be 1 to 2 times the thickness t1 of each of the plurality of heat radiation fin parts 200.

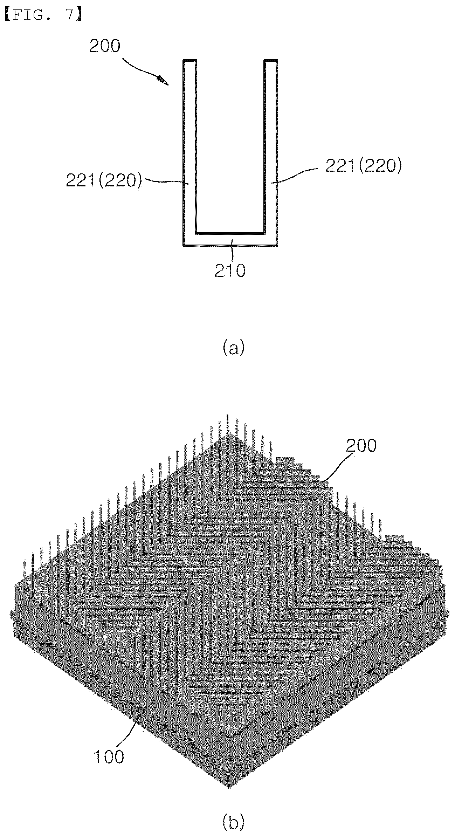

FIGS. 7 to 10 are views illustrating another shape of the heat radiation fin part 200 of the heat sink structure according to the present invention.

In more detail, FIG. 7A is a view illustrating the heat radiation fin part 200 manufactured in an alphabet U shape, and FIG. 7B is a perspective view illustrating a heat sink structure in which the heat radiation fin part 200 having the alphabet U shape illustrated in FIG. 7A is fixed to the heat sink main body part 100 by laser welding.

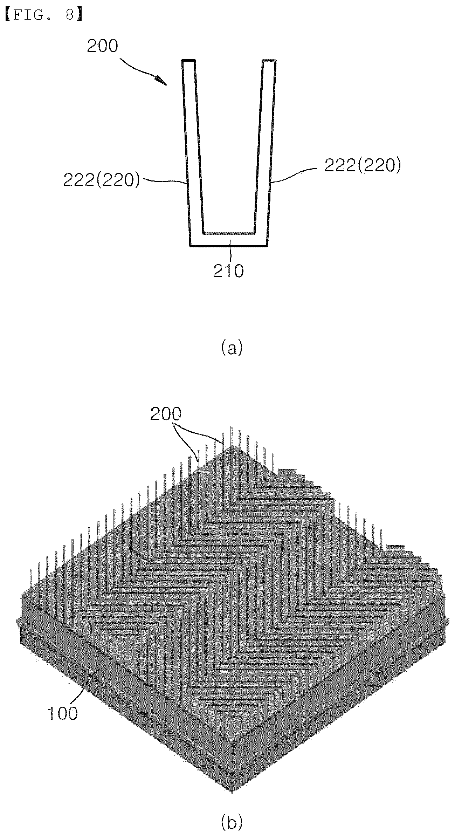

In addition, FIG. 8A is a view illustrating the heat radiation fin part 200 manufactured in an alphabet V shape, and FIG. 8B is a perspective view illustrating a heat sink structure in which the heat radiation fin part 200 having the alphabet V shape illustrated in FIG. 8A is fixed to the heat sink main body part 100 by laser welding.

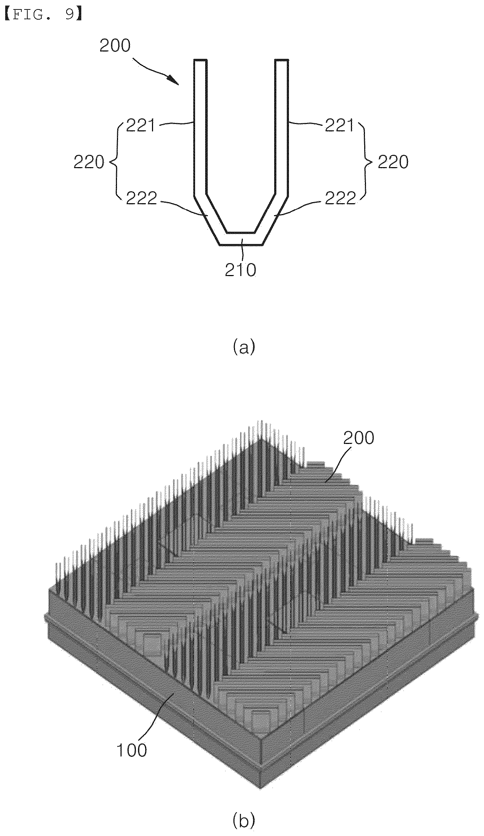

In addition, FIG. 9A is a view illustrating the heat radiation fin part 200 manufactured in a shape made by combining an alphabet V shape and an alphabet U shape, and FIG. 9B is a perspective view illustrating a heat sink structure in which the heat radiation fin part 200 illustrated in FIG. 9A and having the shape made by combining the alphabet V shape and the alphabet U shape is fixed to the heat sink main body part 100 by laser welding.

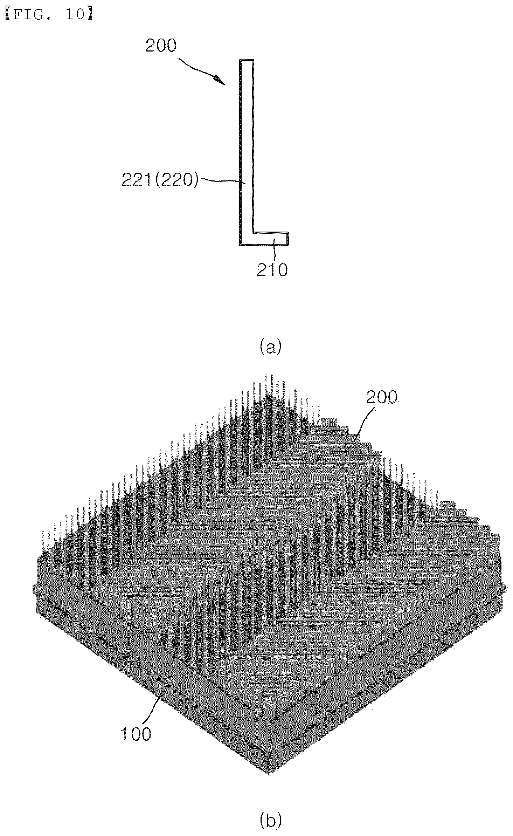

In addition, FIG. 10A is a view illustrating the heat radiation fin part 200 manufactured in an alphabet L shape, and FIG. 10B is a perspective view illustrating a heat sink structure in which the heat radiation fin part 200 having the alphabet L shape illustrated in FIG. 10A is fixed to the heat sink main body part 100 by laser welding.

With reference to FIGS. 7 to 9, the heat radiation fin part 200 may include a plate support member 210, and heat radiation fin members 220 positioned at two opposite ends of the plate support member 210 while standing.

In addition, with reference to FIG. 10, the heat radiation fin part 200 may include the plate support member 210, and the heat radiation fin member 220 provided at any one of the two opposite ends of the plate support member 210 while standing.

That is, the heat radiation fin member 220 may be disposed on at least one of the two opposite ends of the plate support member 210 while standing.

In case that the plurality of welding coupling parts 107 each includes the support block portion 130, the plate support member 210 may be seated on the support block portion 130. Further, in case that each of the plurality of welding coupling parts 107 does not include the support block portion 130, the plate support member 210 may be seated on the heat radiation surface 102 of the heat sink main body part 100.

Specifically, as illustrated in FIG. 7, the heat radiation fin members 220 may include perpendicular fins 221 disposed at the two opposite ends of the plate support member 210 and disposed perpendicularly to the plate support member 210. Alternatively, as illustrated in FIG. 8, the heat radiation fin members 220 may include inclined fins 222 formed at the two opposite ends of the plate support member 210 and inclined such that a distance between the inclined fins 222 increases as the distance from the plate support member 210 increases.

In addition, as illustrated in FIG. 9, the heat radiation fin members 220 may include the inclined fins 222 formed at the two opposite ends of the plate support member 210 and inclined such that the distance between the inclined fins 222 increases as the distance from the plate support member 210 increases, and the perpendicular fins 221 respectively extending from ends of the inclined fins 222 perpendicularly to the plate support member 210.

In addition, as illustrated in FIG. 10, the heat radiation fin member 220 may include the perpendicular fin 221 disposed on any one of the two opposite ends of the plate support member 210 and disposed perpendicularly to the plate support member 210.

That is, with reference to FIGS. 7 and 10, the heat radiation fin member 220 may include the perpendicular fin 221 disposed on at least one of the two opposite ends of the plate support member 210 and disposed perpendicularly to the plate support member 210.

The heat radiation fin member 220 may be manufactured in various publicly-known shapes in accordance with a structure of a heat dissipation design for dissipating heat from a product from which heat is to be dissipated.

Meanwhile, an embodiment of a heat sink manufacturing method according to the present invention includes a preparation step of separately manufacturing the heat sink main body part 100 and the plurality of heat radiation fin parts 200 configured to dissipate heat, and a laser welding step of fixing the plurality of heat radiation fin parts 200 to the heat radiation surface 102 of the heat sink main body part 100 by laser welding so that the plurality of heat radiation fin parts 200 is spaced apart from one another after the preparation step.

For example, in the preparation step, the heat sink main body part 100 is manufactured by casting, and the plurality of heat radiation fin parts 200 is manufactured by cutting a premanufactured metal plate, i.e., an aluminum plate or an aluminum alloy plate.

In the laser welding step, in the state in which the heat radiation fin part 200 stands and the lower end of the heat radiation fin part 200 is seated on the heat radiation surface 102, the portion between one side surface of the heat radiation fin part 200 and the heat radiation surface 102 is irradiated with laser beams in an inclined direction, such that the heat radiation fin part 200 is fixed onto the heat radiation surface 102 by laser welding.

In addition, as another example, the plurality of welding coupling parts 107 protrudes from the heat radiation surface 102 of the heat sink main body part 100 in the preparation step, and the plurality of heat radiation fin parts 200 are respectively coupled to the plurality of welding coupling parts 107 by laser welding in the laser welding step.

Specifically, in the preparation step, the heat sink main body part 100 may be manufactured by casting, and the first heat radiation fin support portion 110 may protrude from the heat radiation surface 102 of the heat sink main body part 100. In this case, in the laser welding step, the lower end of each of the plurality of heat radiation fin parts is disposed at one side of the first heat radiation fin support portion and stands on the heat radiation surface, such that the first heat radiation fin support portion may support one side of each of the plurality of heat radiation fin parts, and one side of each of the plurality of heat radiation fin parts and one side of the first heat radiation fin support portion may be fixed by laser welding.

Alternatively, in the preparation step, the heat sink main body part 100 may be manufactured by casting, and the first heat radiation fin support portion 110 and the second heat radiation fin support portion 120 may protrude from the heat radiation surface 102 of the heat sink main body part 100 and be spaced apart from each other. In this case, in the laser welding step, the lower end of each of the plurality of heat radiation fin parts is inserted between the first heat radiation fin support portion and the second heat radiation fin support portion and stands on the heat radiation surface, such that the first heat radiation fin support portion supports one side of each of the plurality of heat radiation fin parts, the second heat radiation fin support portion supports the other side of each of the plurality of heat radiation fin parts, and one of the portion between one side of each of the plurality of heat radiation fin parts and one side of the first heat radiation fin support portion and the portion between the other side of each of the plurality of heat radiation fin parts and one side of the second heat radiation fin support portion may be fixed by laser welding.

Alternatively, in the preparation step, the heat sink main body part 100 may be manufactured by casting, and the support block portion 130 may protrude from the heat radiation surface 102 of the heat sink main body part 100. In this case, in the laser welding step, the lower end of each of the plurality of heat radiation fin parts may stand on the support block portion and be fixed to the support block portion by laser welding.

Alternatively, in the preparation step, the heat sink main body part 100 may be manufactured by casting, the support block portion 130 may protrude from the heat radiation surface 102 of the heat sink main body part 100, the first heat radiation fin support portion 110 may protrude from one end of the support block portion 130, and the second heat radiation fin support portion 120 may protrude from two opposite ends of the support block portion 130 and be spaced apart from the first heat radiation fin support portion 110. In this case, in the laser welding step, the lower end of each of the plurality of heat radiation fin parts is inserted between the first heat radiation fin support portion and the second heat radiation fin support portion and stands on the support block portion, such that the first heat radiation fin support portion supports one side of each of the plurality of heat radiation fin parts, the second heat radiation fin support portion supports the other side of each of the plurality of heat radiation fin parts, and one of the portion between one side of each of the plurality of heat radiation fin parts and one side of the first heat radiation fin support portion and the portion between the other side of each of the plurality of heat radiation fin parts and one side of the second heat radiation fin support portion may be fixed by laser welding.

For example, in the preparation step, the heat sink main body part 100 is manufactured by casting, and the first heat radiation fin support portion 110 and the second heat radiation fin support portion 120 are manufactured to protrude from the heat radiation surface so that the heat radiation fin part 200 may be inserted between the first heat radiation fin support portion 110 and the second heat radiation fin support portion 120. For example, the laser welding step includes a heat radiation fin assembling step of inserting the heat radiation fin part 200 between the first heat radiation fin support portion 110 and the second heat radiation fin support portion 120, and a heat radiation fin welding step of laser-welding the heat radiation fin part 200 by irradiating any one of the first heat radiation fin support portion 110 and the second heat radiation fin support portion 120 with laser beams after the heat radiation fin assembling step.

In more detail, in the heat radiation fin welding step, the portion between the first heat radiation fin support portion 110 and the heat radiation fin part 200 or the portion between the second heat radiation fin support portion 120 and the heat radiation fin part 200 is irradiated with laser beams in an inclined direction, or the portion between the first heat radiation fin support portion 110 and the heat radiation fin part 200 and the portion between the second heat radiation fin support portion 120 and the heat radiation fin part 200 are simultaneously irradiated with laser beams, such that the heat radiation fin part 200 is fixed by laser welding.

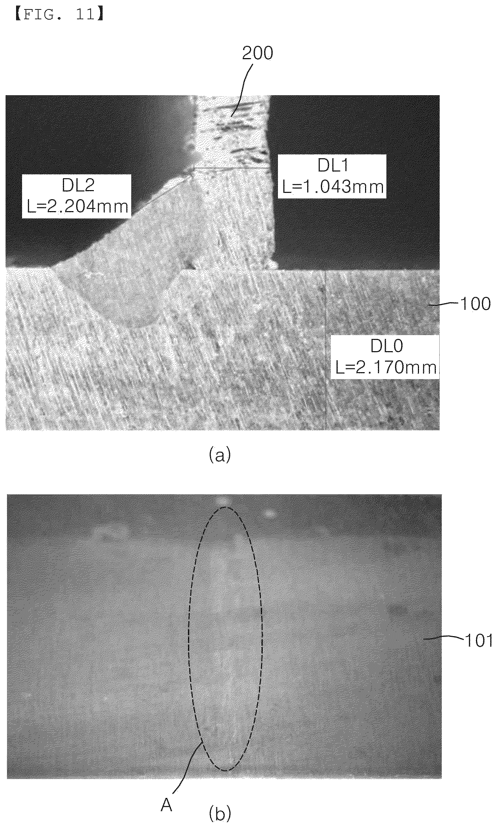

FIG. 11 is a photograph illustrating a first test example in which the heat radiation fin part 200 is laser-welded by the heat sink manufacturing method according to the present invention. In the first test example, fillet welding is performed in a state in which the straight heat radiation fin part 200 having a thickness of 1T (mm) stands on the heat radiation surface 102 of the heat sink main body part 100 having a thickness of 2T (mm).

Table 1 below shows a laser welding condition in the first test example in which laser welding is performed by setting the amount of minimum heat input (output).

**[Table 1]**

| Wavelength | Mode | Power | Speed | Frequency | Wobble length |
|---|---|---|---|---|---|
| 1070 nm | Continuous wave | 900 w | 50 mm/s | 100 Hz | 1 mm |

FIG. 11A is a photograph illustrating an enlarged welded portion, and FIG. 11B is a photograph illustrating a bottom surface of the heat sink main body part 100 after welding.

With reference to FIG. 11A, it can be ascertained that when one side of the heat radiation fin part 200 is fixed by laser welding in the state in which the lower end of the straight heat radiation fin part 200 having a thickness of 1T (mm) is seated directly on the heat radiation surface 102 of the heat sink main body part 100, the rigidity of the laser-welded portion is ensured, but it is difficult to ensure the rigidity of the heat radiation fin part 200 at a side opposite to the welded portion.

In this case, because the heat radiation fin part 200 has an insufficient fixing force against a force generated from the welded portion toward the side opposite to the welded portion, there is a risk of the occurrence of damage when the heat radiation fin part 200 is used. In order to prevent the risk, there is an inconvenience of having to laser-weld both the two opposite sides of the heat radiation fin part 200.

In addition, with reference to FIG. 11B, it can be ascertained that in case that one side of the heat radiation fin part 200 is laser-welded in the state in which the lower end of the straight heat radiation fin part 200 having a thickness of 1T (mm) is seated directly on the heat radiation surface 102 of the heat sink main body part 100, bending deflection occurs in the portion indicated by the dotted line denoted by reference numeral A on the mounting surface 101, which is a bottom surface of the heat sink main body part 100, even though the laser welding is performed by setting the amount of minimum heat input (output).

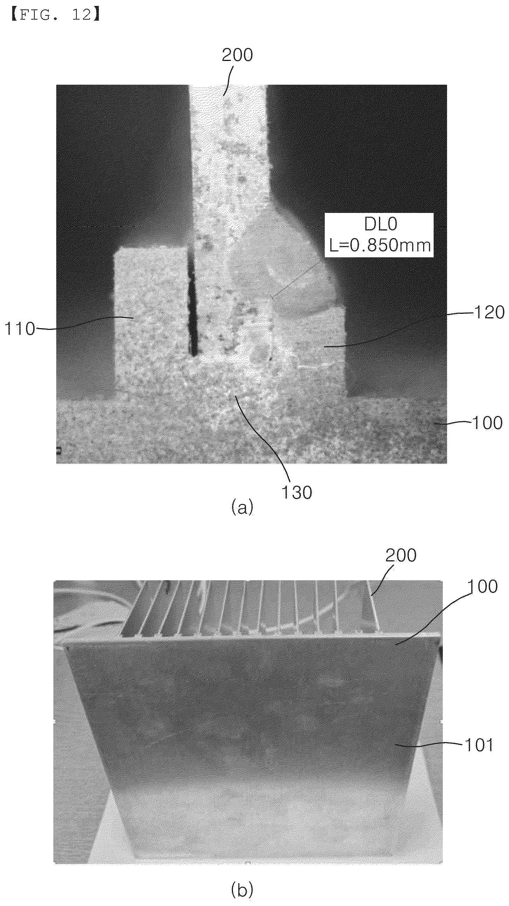

FIG. 12 is a photograph illustrating a second test example in which the heat radiation fin part 200 is laser-welded by the heat sink manufacturing method according to the present invention. In the second test example, the support block portion 130 protrudes from the heat radiation surface of the heat sink main body part 100 having a thickness of 2T (mm), the first heat radiation fin support portion 110 and the second heat radiation fin support portion 120 each having a thickness of 1T (mm) protrude from the support block portion 130, the lower end of the straight heat radiation fin part 200 having a thickness of 1T (mm) is inserted between the first heat radiation fin support portion 110 and the second heat radiation fin support portion 120, and fillet welding is performed by irradiating the portion between the second heat radiation fin support portion 120 and the heat radiation fin part 200 with laser beams in an inclined direction.

Table 2 below shows a laser welding condition in the second test example in which laser welding is performed by setting the amount of heat input (output) larger than that in the first test example.

**[Table 2]**

| Wavelength | Mode | Power | Speed | Frequency | Wobble length |
|---|---|---|---|---|---|
| 1070 nm | Continuous wave | 1250 w | 70 mm/s | 200 Hz | 0.4 mm |

FIG. 12A is a photograph illustrating an enlarged welded portion, and FIG. 12B is a photograph illustrating a bottom surface of the heat sink main body part 100 after welding.

With reference to FIG. 12A, it can be ascertained that the first heat radiation fin support portion 110 reinforces the rigidity of the side opposite to the laser-welded portion by supporting one side of the heat radiation fin part 200 that is not laser-welded, and a part of an upper side of the second heat radiation fin support portion 120 is melted during laser welding, such that the second heat radiation fin support portion 120 serves as a filler material and further increases the rigidity of the laser-welded portion. In addition, with reference to FIG. 12B, it can be ascertained that no bending deflection occurs on the mounting surface 101 that is the bottom surface of the heat sink main body part 100.

As described above, according to the present invention, the heat sink main body part 100 and the plurality of heat radiation fin parts 200 are manufactured separately, and then the plurality of heat radiation fin parts 200 is fixed to the heat sink main body part 100 by laser welding, such that the thicknesses of and the intervals between the plurality of heat radiation fin parts 200 may be minimized, the heat dissipation performance may be improved, and the weight may be significantly reduced. In addition, according to the present invention, only the heat sink main body part 100 is manufactured by casting, which may significantly reduce the production lead time and the manufacturing costs.

A person skilled in the art may understand that the present invention may be carried out in other specific forms without changing the technical spirit or the essential characteristics of the present invention. Therefore, it should be understood that the above-described embodiments are illustrative in all aspects and do not limit the present invention. The scope of the present invention is represented by the claims to be described below rather than the detailed description, and it should be interpreted that the meaning and scope of the claims and all the changes or modified forms derived from the equivalent concepts thereto fall within the scope of the present invention.

### [Industrial Applicability]

The present invention provides the heat sink structure, in which the heat sink main body part and the plurality of heat radiation fin parts are manufactured separately, and the plurality of heat radiation fin parts is fixed to the heat sink main body part by laser welding, such that thicknesses of and intervals between the plurality of heat radiation fin parts may be minimized, and manufacturing costs may be significantly reduced, and a manufacturing method thereof.

## Claims

1. A heat sink structure comprising:
a heat sink main body part having a mounting surface provided on one surface thereof so that a product from which heat is to be dissipated is positioned on the mounting surface, and having a heat radiation surface configured to dissipate heat and provided on a surface different from one surface; and
a plurality of heat radiation fin parts fixed by laser welding while standing on the heat radiation surface of the heat sink main body part.

2. The heat sink structure of claim 1, wherein a plurality of welding coupling parts protrudes from the heat radiation surface of the heat sink main body part, and the plurality of heat radiation fin parts is coupled to the plurality of welding coupling parts by laser welding.

3. The heat sink structure of claim 2, wherein the plurality of welding coupling parts each comprises a first heat radiation fin support portion protruding from the heat radiation surface,
wherein a lower end of each of the plurality of heat radiation fin parts is disposed at one side of the first heat radiation fin support portion and stands on the heat radiation surface,
wherein the first heat radiation fin support portion supports one side of each of the plurality of heat radiation fin parts, and
wherein a portion between one side of each of the plurality of heat radiation fin parts and one side of the first heat radiation fin support portion is fixed by laser welding.

4. The heat sink structure of claim 2, wherein the plurality of welding coupling parts each comprises:
a first heat radiation fin support portion protruding from the heat radiation surface; and
a second heat radiation fin support portion protruding from the heat radiation surface and spaced apart from the first heat radiation fin support portion,
wherein a lower end of each of the plurality of heat radiation fin parts is inserted between the first heat radiation fin support portion and the second heat radiation fin support portion and stands on the heat radiation surface,
wherein the first heat radiation fin support portion supports one side of each of the plurality of heat radiation fin parts,
wherein the second heat radiation fin support portion supports the other side of each of the plurality of heat radiation fin parts, and
wherein one of a portion between one side of each of the plurality of heat radiation fin parts and one side of the first heat radiation fin support portion and a portion between the other side of each of the plurality of heat radiation fin parts and one side of the second heat radiation fin support portion is fixed by laser welding.

5. The heat sink structure of claim 2, wherein the plurality of welding coupling parts each comprises a support block portion protruding from the heat radiation surface, and
wherein a lower end of each of the plurality of heat radiation fin parts stands on the support block portion and is fixed to the support block portion by laser welding.

6. The heat sink structure of claim 2, wherein the plurality of welding coupling parts each comprises:
a support block portion protruding from the heat radiation surface;
a first heat radiation fin support portion protruding from one end of the support block portion; and
a second heat radiation fin support portion protruding from the other end of the support block portion and spaced apart from the first heat radiation fin support portion,
wherein a lower end of each of the plurality of heat radiation fin parts is inserted between the first heat radiation fin support portion and the second heat radiation fin support portion and stands on the support block portion,
wherein the first heat radiation fin support portion supports one side of each of the plurality of heat radiation fin parts,
wherein the second heat radiation fin support portion supports the other side of each of the plurality of heat radiation fin parts, and
wherein one of a portion between one side of each of the plurality of heat radiation fin parts and one side of the first heat radiation fin support portion and a portion between the other side of each of the plurality of heat radiation fin parts and one side of the second heat radiation fin support portion is fixed by laser welding.

7. The heat sink structure of claim 3, wherein a thickness of the first heat radiation fin support portion is 0.7 to 1.1 times a thickness of each of the plurality of heat radiation fin parts.

8. The heat sink structure of claim 7, wherein a height of the first heat radiation fin support portion is 1 to 2 times the thickness of each of the plurality of heat radiation fin parts.

9. The heat sink structure of claim 4, wherein a thickness of the first heat radiation fin support portion and a thickness of the second heat radiation fin support portion are each 0.7 to 1.1 times a thickness of each of the plurality of heat radiation fin parts.

10. The heat sink structure of claim 9, wherein a height of the first heat radiation fin support portion and a height of the second heat radiation fin support portion are each 1 to 2 times the thickness of each of the plurality of heat radiation fin parts.

11. The heat sink structure of claim 5, wherein a thickness of the support block portion is 2.4 to 3.3 times a thickness of each of the plurality of heat radiation fin parts.

12. The heat sink structure of claim 6, wherein a thickness of the first heat radiation fin support portion and a thickness of the second heat radiation fin support portion are each 0.7 to 1.1 times a thickness of each of the plurality of heat radiation fin parts, and
wherein a thickness of the support block portion is 2.4 to 3.3 times a thickness of each of the plurality of heat radiation fin parts.

13. The heat sink structure of claim 12, wherein a height of the first heat radiation fin support portion and a height of the second heat radiation fin support portion are 1 to 2 times the thickness of each of the plurality of heat radiation fin parts.

14. The heat sink structure of claim 1, wherein the plurality of heat radiation fin parts each comprises:
a plate support member; and
a heat radiation fin member disposed on at least one of two opposite ends of the plate support member while standing.

15. The heat sink structure of claim 14, wherein the heat radiation fin member comprises a perpendicular fin disposed on at least one of the two opposite ends of the plate support member and disposed perpendicularly to the plate support member.

16. The heat sink structure of claim 14, wherein the heat radiation fin members comprise inclined fins formed at the two opposite ends of the plate support member and inclined such that a distance between the inclined fins increases as the distance from the plate support member increases.

17. The heat sink structure of claim 16, wherein the heat radiation fin member further comprises a perpendicular fin extending from an end of the inclined fin perpendicularly to the plate support member.

18. A heat sink structure manufacturing method comprising:
a preparation step of separately manufacturing a heat sink main body part, which has a mounting surface provided on one surface thereof so that a product from which heat is to be dissipated is positioned on the mounting surface and has a heat radiation surface configured to dissipate heat and provided on a surface different from one surface, and a plurality of heat radiation fin parts configured to dissipate heat; and
a laser welding step of fixing the plurality of heat radiation fin parts to the heat radiation surface of the heat sink main body part by laser welding so that the plurality of heat radiation fin parts is spaced apart from one another.

19. The heat sink structure manufacturing method of claim 18, wherein in the preparation step, the heat sink main body part is manufactured by casting, and the plurality of heat radiation fin parts is manufactured by cutting a premanufactured metal plate.

20. The heat sink structure manufacturing method of claim 18, wherein a plurality of welding coupling parts protrudes from the heat radiation surface of the heat sink main body part in the preparation step, and
wherein the plurality of heat radiation fin parts is respectively coupled to the plurality of welding coupling parts by laser welding in the laser welding step.
